# EUROPEAN PATENT SPECIFICATION

(11) **EP 3 368 944 B1**
(45) Date of publication and mention of the grant of the patent: **16.12.2020**
(21) Application number: 15895854.6
(22) Date of filing: 29.10.2015
(51) Int. Cl.: H01L 27/12, H01L 27/07, G02F 1/1368, G02F 1/1343

(54) **ARRAY SUBSTRATE AND FABRICATING METHOD THEREOF, DISPLAY PANEL, AND DISPLAY APPARATUS**
ARRAYSUBSTRAT UND HERSTELLUNGSVERFAHREN DAFÜR, ANZEIGETAFEL UND ANZEIGEVORRICHTUNG
SUBSTRAT DE MATRICE ET PROCÉDÉ DE FABRICATION DE CELUI-CI, PANNEAU D'AFFICHAGE ET APPAREIL D'AFFICHAGE

(43) Date of publication of application: 05.09.2018
(73) Proprietor: BOE Technology Group Co., Ltd., Beijing 100015 (CN)
(72) Inventor: NING, Ce, Beijing 100176 (CN); YANG, Wei, Beijing 100176 (CN)
(74) Representative: Cohausz & Florack
(86) International application number: PCT/CN2015/093193
(87) International publication number: WO 2017/070890

(56) References cited:
- WO-A1-2012/044344
- WO-A1-2012/044344
- CN-A- 103 208 528
- CN-C- 100 399 179
- JP-A- 2007 298 976
- US-A1- 2002 125 480
- US-A1- 2013 240 886

## Description

### FIELD

The present disclosure generally relates to the field of display technologies and, more particularly, relates to an array substrate and a fabricating method thereof, a display panel, and a display apparatus.

### BACKGROUND

Thin film transistor liquid crystal display (TFT-LCD) has the advantages of compact size, low power consumption, and radiation free. The ADS (advanced super dimension switch) technology is capable of improving the image quality of TFT-LCD products.

Amorphous silicon (a-Si) techniques are often used for forming large-size LCD devices at low temperatures. However, the bandgap of a-Si material is only about 1.7V, opaque to visible light but photosensitive in the visible range. An opaque metal mask or black matrix may then be used to block out the light. This increases complexity and cost for fabricating the LCD devices with reduced reliability and aperture ratio. In many cases, to obtain sufficient brightness, light intensity has to be increased, which in turn increases power consumption of the display device.

Further, it is difficult to increase mobility of hydrogenated amorphous silicon semiconductor to exceed 1cm²·V⁻¹·s⁻¹. Existing hydrogenated amorphous silicon TFT faces challenges from demanding for LCD TVs with ever-increasing sizes and for high-performance driving circuit.

The disclosed array substrates, fabricating methods, and display devices are directed to at least partially alleviate one or more problems set forth above and to solve other problems in the art.

US 2013/0240886 discloses an array substrate with stacked TFTs.

JP 2007-298976 discloses an active layer and a common electrode formed from the same layer.

### BRIEF SUMMARY

One aspect or embodiment of the present disclosure provides a method for fabricating an array substrate. A first active layer, source/drain regions and common electrodes are formed on the substrate by a first patterning process. A first gate insulating layer is formed on the first active layer. A gate electrode is formed on the first gate insulating layer. A second gate insulating layer is formed on the common electrodes and the gate electrode. Via-holes are formed, by a second patterning process, in the second gate insulating layer to expose surface portions of the common electrodes. Source/drain electrodes are formed, by a third patterning process, and electrically connected with the source/drain regions through the via-holes. A second active layer and pixel electrodes are formed on the second gate insulating layer by a fourth patterning process.

Optionally, the step of forming a first active layer, the source/drain regions and common electrodes on the substrate includes forming a first oxide layer between the substrate and the first gate insulating layer. The first oxide layer has a first portion under the first gate insulating layer used as the first active layer, and has a second portion on the substrate being converted into a conductive layer used as the source/drain regions and the common electrodes.

Optionally, the second portion of the first oxide layer is converted into the conductive layer by a plasma.

Optionally, the second portion of the first oxide layer is converted into the conductive layer by an ion implantation process.

Optionally, a first patterned photoresist layer is used as an etch mask to form the first active layer, the source/drain regions, the common electrodes, the first gate insulating layer, and the gate electrode.

Optionally, a first insulating layer is formed on the first oxide layer, and a metal layer is formed on the first insulating layer. The first patterned photoresist layer is formed on the metal layer and used as the etch mask.

Optionally, a through-hole is formed in the metal layer, the first insulating layer, and the first oxide layer to expose the substrate. A first portion of the first patterned photoresist layer containing the through-hole is removed to leave a second portion of the first patterned photoresist layer remain on the metal layer. The second portion of the first patterned photoresist layer is used as an etch mask to remove portions of the metal layer and the first insulating layer, to provide the first gate insulating layer and the gate electrode.

Optionally, the step of using the second portion of the first patterned photoresist layer as an etch mask to remove portions of the first insulating layer includes a dry etching process using plasma.

Optionally, the dry etching process is controlled to use the plasma to simultaneously treat the first oxide layer to convert the first oxide layer that is not under the first gate insulating layer into the conductive layer.

Optionally, the step of forming a second active layer and pixel electrodes includes: forming a second oxide layer on the second gate insulating layer and on the source/drain electrodes, and forming a protection layer on the second oxide layer.

Optionally, after forming the source/drain electrodes and before forming the second active layer, a second patterned photoresist layer is formed on the protection layer. The second patterned photoresist layer is used on the protection layer as an etch mask to form the second active layer and the pixel electrodes on the second gate insulating layer.

Another aspect or embodiment of the present disclosure provides an array substrate. The array substrate includes a first layer structure including a first active layer, source/drain regions and common electrodes on the substrate, the first active layer, the source/drain regions and the common electrodes are located in a same layer; a first gate insulating layer on the first active layer; a gate electrode on the first gate insulating layer; a second gate insulating layer on , the source/drain regions, the common electrodes and the gate electrode; source/drain electrodes in the second gate insulating layer and connecting to the source/drain regions; a second active layer on the second gate insulating layer, above the gate electrode, and between the source/drain electrodes; and pixel electrodes on the second gate insulating layer.

Optionally, the first layer is a first oxide layer between the substrate and the first gate insulating layer. The first oxide layer has a first portion under the first gate insulating layer defined as the first active layer, and has a second portion being converted into a conductive layer defined as the common electrodes.

Optionally, the second portion of the first oxide layer is converted into the conductive layer by a plasma. Optionally, the second portion of the first oxide layer is converted into the conductive layer by an ion implantation process.

Optionally, a second oxide layer is on the second gate insulating layer and on the source/drain electrodes. The second oxide layer has a first portion over the first gate insulating layer defined as the second active layer, and has a second portion being converted into a conductive layer defined as the pixel electrodes.

Optionally, the second portion of the second oxide layer is converted into the conductive layer by a plasma or an ion implantation.

Optionally, each of the first and second active layers has a thickness ranging from about 30 nm to about 50 nm.

Optionally, each of the first and second active layers is made of indium gallium zinc oxide (IGZO), indium zinc oxide (IZO), indium-tin-zinc-oxide (ITZO), zinc oxide (ZnO), or a combination thereof.

Another aspect or embodiment of the present disclosure provides a display panel includes the disclosed array substrate.

Another aspect or embodiment of the present disclosure provides a display apparatus includes the disclosed display panel.

Other aspects or embodiments of the present disclosure can be understood by those skilled in the art in light of the description, the claims, and the drawings of the present disclosure.

### BRIEF DESCRIPTION OF THE DRAWINGS

The following drawings are merely examples for illustrative purposes according to various disclosed embodiments and are not intended to limit the scope of the present disclosure.

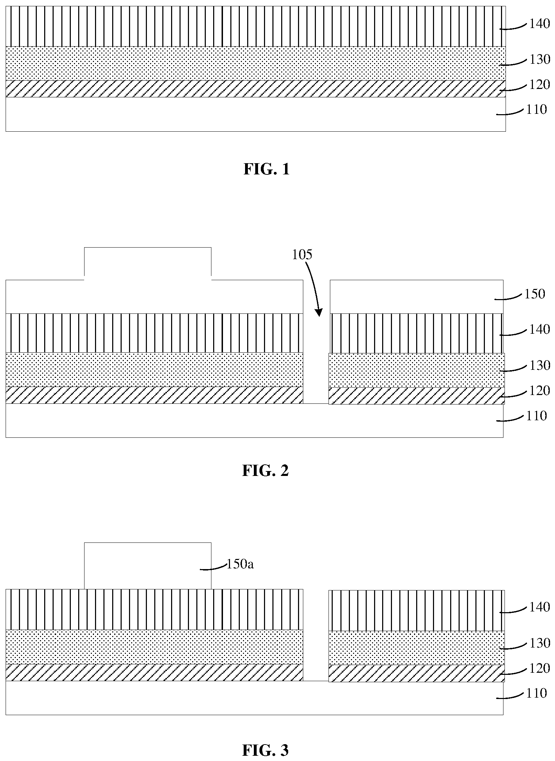

FIGS. 1-8 illustrate cross sectional structures of an exemplary array substrate at certain stages during its formation according to various embodiments of the present disclosure.

### DETAILED DESCRIPTION

The objectives, features and advantages of the present disclosure may be more fully understood by persons of ordinary skill in the art with reference to the exemplary embodiments which are described in detail below and are illustrated in the accompanying drawings. Wherever possible, the same reference numbers will be used throughout the drawings to refer to the same or like parts.

The present disclosure provides an array substrate and fabricating method thereof, and a display panel including the array substrate, and a display apparatus including the display panel.

FIGS. 1-8 illustrate cross sectional structures of an exemplary array substrate at certain stages during its formation according to various embodiments of the present disclosure.

In FIG. 1, a substrate 110 is provided. A first oxide layer 120, a first insulating layer 130, and a metal layer 140 are sequentially formed on the substrate 110.

The substrate 110 may be an optically transparent substrate. For example, the substrate 110 may be made of glass, quartzor plastic. The substrate 110 may be, for example, a flexible substrate, made of a polymer. Of course, other suitable substrates may be used for the substrate 110.

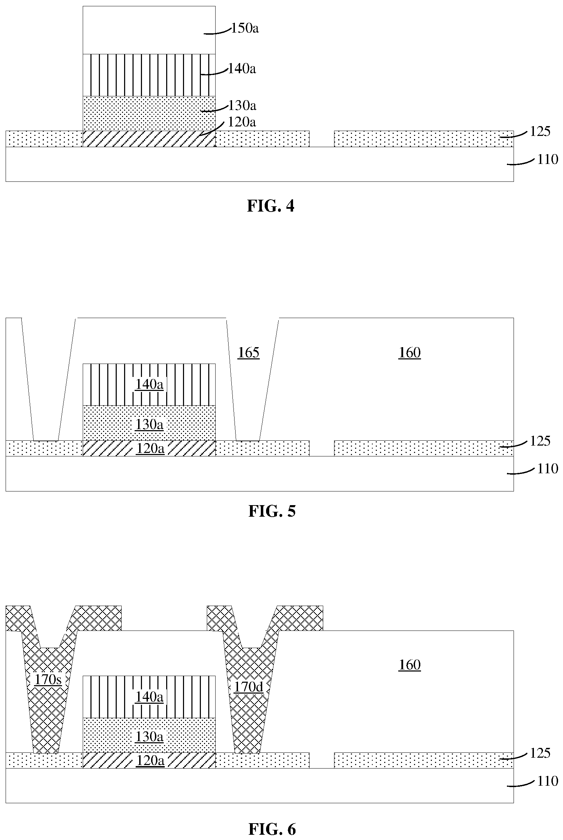

The first oxide layer 120 may be formed on the substrate 110. The first oxide layer 120 may be formed by, for example, a magnetron sputtering process. The first oxide layer 120 may have a thickness ranging from about 30 nm to about 50 nm. The first oxide layer 120 may be made of indium gallium zinc oxide (IGZO), indium zinc oxide (IZO), indium-tin-zinc-oxide (ITZO), zinc oxide (ZnO), etc. The first oxide layer 120 may subsequently be processed to form a first active layer, e.g., first active layer 120a in FIGS. 4-8, source/drain regions and common electrodes, e.g., common electrodes 125 in FIGS. 4-8. In one embodiment, the first oxide layer 120 may be formed by a metal oxide semiconductor.

The first insulating layer 130 is formed on the first oxide layer 120. The first insulating layer 130 is used to form a first gate insulating layer subsequently.

The first insulating layer 130 may be made of an insulating material such as, for example, silicon nitride (SiNₓ), silicon oxide (SiOₓ), silicon oxynitride (SiOₓN_{y}), aluminum oxide (AlOₓ), yttrium oxide (Y₂O₃), hafnium oxide (HfOx), zirconium oxide (ZrOₓ), aluminum nitride (AlN), aluminum oxynitride (AlNO), titanium oxide (TiOₓ), barium titanate (BaTiO₃), lead titanate (PbTiO₃), or a combination thereof.

In one embodiment, the first insulating layer 130 may be formed by a plasma-enhanced chemical vapor deposition (PECVD) process. The first insulating layer 130 may have a thickness ranging from about 300 nm to about 400 nm.

The metal layer 140 may be formed by, for example, a magnetron sputtering process. The metal layer 140 may have a thickness ranging from about 200 nm to about 300 nm. The metal layer 140 may include one or more layers with each layer formed by one or more metal material. The metal material may include aluminum (Al), copper (Cu), molybdenum (Mo), titanium (Ti), nickel (Ni), tungsten (W), gold (Au), palladium (Pd), platinum (Pt), chromium (Cr), neodymium (Nd), zinc (Zn), cobalt (Co), manganese (Mn), and any mixtures or alloys thereof.

In FIG. 2, a first patterned photoresist layer 150 may be formed over the metal layer 140, e.g., using a standard photolithographic process. The first patterned photoresist layer 150 may have an opening there-through to expose the underlying metal layer 140. The first patterned photoresist layer 150 may then be used as an etch mask to etch the metal layer 140, the first insulating layer 130, and the first oxide layer 120 to form a through-hole 105 in a first etching process, until a surface portion of the substrate 110 is exposed.

The first etching process for forming the through-hole 105 may include a wet etching, a dry etching, or any combinations thereof. In one embodiment, the first etching process may include a wet etching to etch the metal layer 140, a dry etching to etch the first insulating layer 130, and another wet etching to etch the first oxide layer 120. In another embodiment, the first etching process may include one or more dry etching processes to etch the metal layer 140, the first insulating layer 130, and the first oxide layer 120, either together or separately. Still in another embodiment, the first etching process may include one or more wet etching processes to etch the metal layer 140, the first insulating layer 130, and the first oxide layer 120, either together or separately.

As shown in FIG. 2, the first patterned photoresist layer 150 may have a first portion, corresponding to a subsequently-formed active layer/gate electrode, with a thickness greater than a second portion of the first patterned photoresist layer 150. The second portion of the first patterned photoresist layer 150 contains the through-hole 105.

In FIG. 3, the second portion of the first patterned photoresist layer 150 may be removed from the metal layer 140 to leave a remaining photoresist layer 150a. For example, the second portion of the first patterned photoresist layer 150 may be removed by an ashing process.

In FIG. 4, after the first etching process for forming the through-hole 105 through the metal layer 140, the first insulating layer 130, and the first oxide layer 120, a second etching process may be performed to further etch the metal layer and the first insulating layer using the remaining photoresist layer 150a as an etch mask.

After the second etching process, a gate electrode 140a and a first gate insulating layer 130a may remain under the remaining photoresist layer 150a. A portion of the first oxide layer 120 under the remaining photoresist layer 150a may be used as a first active layer 120a on the substrate 110.

In one embodiment, the first gate insulating layer 130a may be formed by a dry etching involved in at least one of the first and second etching processes as disclosed in FIG. 2 and FIG. 4. The dry etching of the insulating layer 130 may use plasma, for example, including O₂ or O₂ and fluorine (F).

During dry etching of the insulating layer 130 for forming the first gate insulating layer 130a, the exposed first oxide layer 120 that is not under the remaining photoresist layer 150a may be simultaneously treated by the plasma to turn the exposed first oxide layer into a conductive layer, for example, a transparent conductive layer. The transparent conductive layer may be performed an etching process thereon, such that a first portion of the conductive layer is formed as common electrodes 125, and a second portion of the conductive layer connecting with the first active layer is formed as source/drain regions.

In various embodiments, the first oxide layer 120 that is not under the remaining photoresist layer 150a, or the common electrodes 125, may be doped by an ion implantation process to convert the first oxide layer into a conductive layer, for example, a transparent conductive layer. The transparent conductive layer may be performed an etching process thereon, such that a first portion of the conductive layer is formed as common electrodes 125, and a second portion of the conductive layer connecting with the first active layer is formed as source/drain regions.

In various embodiments, while the common electrodes 125 are formed, common lines (not shown) may also be formed simultaneously.

As such, by using the first patterned photoresist layer 150, the gate electrode 140a, the first gate insulating layer 130a, the first active layer 120a, source/drain regions and the common electrodes 125 may be formed.

In FIG. 5, after the remaining photoresist layer 150a in FIG. 4 is removed, a second gate insulating layer 160 is formed on the common electrodes 125, the exposed portion of the substrate 110, and the gate electrode 140a. In addition, via-holes 165 may be formed through the second gate insulating layer 160 and on surface portions of the source/drain regions.

For example, the via-holes 165 may be formed by a standard photolithographic process, for example, using a second patterned photoresist layer (not illustrated) formed on a second gate insulating layer as an etch mask.

In FIG. 6, a source electrode 170s and a drain electrode 170d are formed in the via-holes 165 to connect to the source/drain regions, respectively. The source electrode 170s and the drain electrode 170d may also have portions formed on surface of the second gate insulating layer 160.

In various embodiments, the source electrode 170s and the drain electrode 170d may be formed by another standard photolithographic process. For example, an electrode material may be deposited in the via-holes 165 and on the entire surface of the second gate insulating layer 160. A third patterned photoresist layer (not illustrated) may be formed on the electrode material, and may be used as an etch mask to etch the electrode material to expose the second gate insulating layer 160 and to form the source electrode 170s and the drain electrode 170d, as shown in FIG. 6. In other cases, data lines may be formed simultaneously along with the source/drain electrodes 170 s/d.

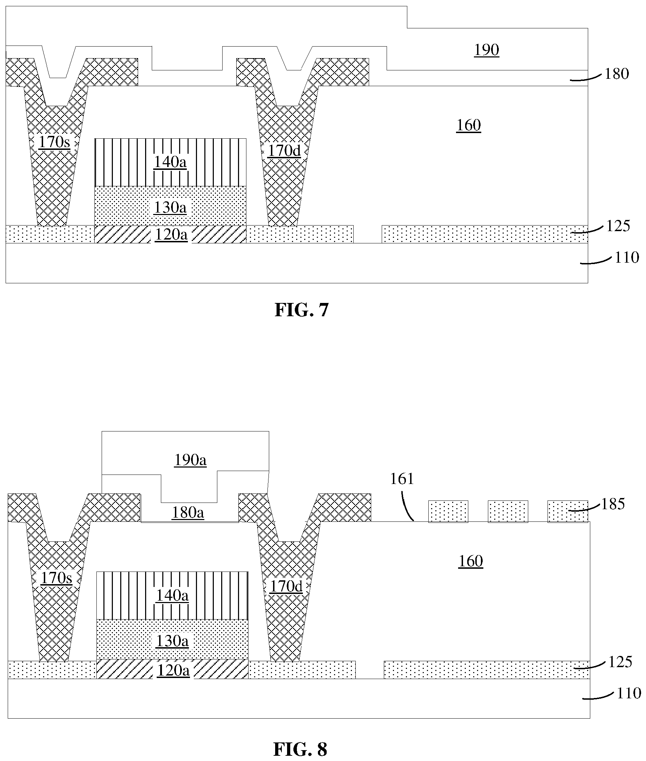

In FIG. 7, a second oxide layer 180 îs formed on the source electrode 170s and the drain electrode 170d, and on the exposed surface of the second gate insulating layer 160. A protection layer 190 may be formed on the second oxide layer 180.

In various embodiments, the second oxide layer 180 may be the same as or similar to the first oxide layer 120 in FIG. 1.

The protection layer 190 may be a passivation layer formed by insulating material(s). For example, the protection layer 190 may be made of silicon nitride (SiNₓ), silicon oxide (SiOₓ), silicon oxynitride (SiOₓN_{y}), etc. The protection layer 190 may be formed by a PECVD process.

In FIG. 8, a second active layer 180a, a patterned protection layer 190a, and pixel electrodes 185 may be formed by processing the second oxide layer 180 and the protection layer 190 in FIG. 7. This processing may be similar to the processes shown in FIGS. 1-4, where the first oxide layer 120 and the first insulating layer 130 are processed to form the first active layer 120a, the first gate insulating layer 130a, the source/drain regions and the common electrodes 125.

For example, a fourth patterned photoresist layer (not illustrated) may be formed on the protection layer 190 in FIG. 7. The fourth patterned photoresist layer may have openings there-through to expose underlying protection layer 190. The fourth patterned photoresist layer may then be used as an etch mask to etch the second oxide layer 180 and the protection layer 190 to form through-holes in a third etching process, until surface portions 161 of the second gate insulating layer 160 are exposed, leaving a plurality of second oxide layer portions thereon. The third etching process may be the same or similar to the first etching process for forming the through-hole 105 as illustrated in FIG. 2.

Similarly to the first patterned photoresist layer 150, the fourth patterned photoresist layer may have a first portion, corresponding to a subsequently-formed second active layer 180a, with a thickness greater than other portions of the fourth patterned photoresist layer.

The other portions of the fourth patterned photoresist layer may be removed to leave a fourth remaining photoresist layer used as an etch mask to further etch the protection layer 190 and the second oxide layer 180 by a fourth etching process. In various embodiments, the fourth etching process may be the same or similar to the second etching process illustrated in FIG. 4.

The fourth remaining photoresist layer on the patterned protection layer 190a and the second active layer 180a may then be removed, with the plurality of second oxide layer portions on the second gate insulating layer 160 that is not over the gate electrode 140a.

In one embodiment, the protection layer 190 may be patterned by a dry etching involved in at least one of the third insulating layer and the fourth etching process to form the patterned protection layer 190a. The dry etching of the protection layer 190 may use plasma, for example, including O2 or O2 and fluorine (F).

During dry etching of the protection layer 190 for forming the patterned protection layer 190a, the plurality of second oxide layer portions on the second gate insulating layer 160 that is not over the gate electrode 140a may be simultaneously treated by the plasma to convert the exposed second oxide layer into a transparent conductive layer. The transparent conductive layer may be used as pixel electrodes 185 as shown in FIG. 8.

In various embodiments, the plurality of second oxide layer portions on the second gate insulating layer 160 that is not over the gate electrode 140a may be treated by an ion implantation process to convert the exposed second oxide layer into a conductive layer to form the pixel electrodes 185.

As such, by using the fourth patterned photoresist layer, the second active layer 180a, the patterned protection layer 190a, and the pixel electrodes 185 may be formed as shown in FIG. 8.

In this manner, the formed array substrate thus has a dual-active layer structure having the first active layer 120 and the second active layer 180a. In the embodiments, the disclosed array substrate is formed by four patterning processes, each patterning process uses a patterned photoresist layer as an etch mask for the corresponding patterning process.

In a first patterning process, a first oxide layer such as a metal oxide layer may be deposited on a substrate and a metal layer may be deposited on the first oxide layer. By using the first patterning process, the gate electrode, the first gate insulating layer, the first active layer, the source/drain regions, common electrodes, and common electrode lines are formed. In a second patterning process, a second gate insulating layer is deposited and via-holes are formed in the second gate insulating layer using a second patterning process.

In a third patterning process, source/drain electrode material is deposited and the third patterning process is used to form source/drain electrodes and data lines. In a fourth patterning process, a second oxide layer and a protective layer are formed, and by using the fourth patterning process, a second active layer, pixel electrodes, and a patterned protective layer, are formed.

Thus, entire process for forming the disclosed array substrate may only use four patterning processes to form the ADS (advanced super dimension switch) structure. The dual active layer structure may greatly improve on-state current of the resultant display device, and reduce the pixel charging time. This benefits the resultant display device with large size, with high pixels-per-inch (PPI), and with high frequency. The resultant display device may ensure low cost and performance stability. The conductive layer may be formed by treating the metal oxide semiconductor, which greatly reduces cost in materials and manufacture.

Various embodiments thus include a display panel and a display apparatus. The display panel may include the disclosed array substrates. The display apparatus includes the disclosed display panel. The disclosed display apparatus may be used in a liquid crystal display (LCD) device, organic light-emitting diode (OLED), an electronic paper, a mobile phone, a tablet computer, a television, a monitor, a laptop, a digital photo frame, a navigation system, and/or other products with display function.

## Claims

1. A method for fabricating an array substrate, comprising:
forming, by a first patterning process, a first active layer (120a), source/drain regions and common electrodes (125) on a substrate (110), forming a first gate insulating layer (130a) on the first active layer (120a), and forming a gate electrode (140a) on the first gate insulating layer
forming a second gate insulating layer (160) on the common electrodes (125) and the gate electrode (140a), and forming, by a second patterning process, via-holes in the second gate insulating layer (160) to expose surface portions of the common electrodes (125);
forming, by a third patterning process, source/drain electrodes (170 s/d) electrically connected with the source/drain regions through the via-holes; and
forming, by a fourth patterning process, a second active layer (180a) above the gate electrode and pixel electrodes on the second gate insulating layer (160).

2. The method according to claim 1, wherein:
the step of forming a first active layer (120a), the source/drain regions and common electrodes (125) on the substrate (110) comprises: forming a first oxide layer (120) between the substrate (110) and the first gate insulating layer (130a), and
the first oxide layer (120) has a first portion under the first gate insulating layer (130a) used as the first active layer (120a), and has a second portion on the substrate (110) being converted into a conductive layer used as the source/drain regions and the common electrodes (125).

3. The method according to claim 2, wherein the second portion of the first oxide layer (120) is converted into the conductive layer by a plasma.

4. The method according to claim 2, wherein the second portion of the first oxide layer (120) is converted into the conductive layer by an ion implantation process.

5. The method according to claim 2, further including:
using a first patterned photoresist layer (150) as an etch mask to form the first active layer (120a), the source/drain regions, the common electrodes (125), the first gate insulating layer (130a), and the gate electrode (140a) ;
preferably, further including:
forming a first insulating layer (130) on the first oxide layer (120), and a metal layer on the first insulating layer (130), and
forming the first patterned photoresist layer (150) on the metal layer used as the etch mask,
preferably, further including:
forming a through-hole (105) in the metal layer, the first insulating layer (130), and the first oxide layer (120) to expose the substrate (110),
removing a first portion of the first patterned photoresist layer (150) containing the through-hole (105) to leave a second portion of the first patterned photoresist layer (150) remain on the metal layer, and
using the second portion of the first patterned photoresist layer (150) as an etch mask to remove portions of the metal layer and the first insulating layer (130), to provide the first gate insulating layer (130a) and the gate electrode (140a),
preferably, wherein the step of using the second portion of the first patterned photoresist layer (150) as an etch mask to remove portions of the first insulating layer (130) includes a dry etching process using plasma,
preferably, wherein the dry etching process is controlled to use the plasma to simultaneously treat the first oxide layer (120) to convert the first oxide layer (120) that is not under the first gate insulating layer (130a) into the conductive layer.

6. The method according to claim 1, wherein the step of forming a second active layer (180a) and pixel electrodes includes:
forming a second oxide layer(180) on the second gate insulating layer (160) and on the source/drain electrodes (170 s/d), and
forming a protection layer(190) on the second oxide layer(180),
preferably, further including:
after forming the source/drain electrodes (170 s/d) and before forming the second active layer (180a), forming a second patterned photoresist layer on the protection layer(190), and
using the second patterned photoresist layer on the protection layer (190) as an etch mask to form the second active layer (180a) and the pixel electrodes on the second gate insulating layer (160).

7. An array substrate, comprising:
a first layer structure comprising a first active layer (120a), source/drain regions and common electrodes (125) on a substrate (110), the first active layer (120a), the source/drain regions and the common electrodes (125) are formed from a same layer;
a first gate insulating layer (130a) on the first active layer (120a);
a gate electrode (140a) on the first gate insulating layer (130a);
a second gate insulating layer (160) on the source/drain regions, the common electrodes (125) and the gate electrode (140a);
source/drain electrodes (170 s/d) in the second gate insulating layer (160) and connecting to the source/drain regions;
a second active layer (180a) on the second gate insulating layer (160), above the gate electrode (140a), and between the source/drain electrodes (170 s/d); and
pixel electrodes on the second gate insulating layer (160).

8. The array substrate according to claim 7, further including:
a second oxide layer (180) on the second gate insulating layer (160) and on the source/drain electrodes (170 s/d),
wherein the second oxide layer(180) has a first portion over the first gate insulating layer (130a) defined as the second active layer (180a), and has a second portion being converted into a conductive layer defined as the pixel electrodes,
preferably, wherein:
the second portion of the second oxide layer (180) is converted into the conductive layer by a plasma or an ion implantation.

9. The array substrate according to claim 7, wherein:
each of the first and second active layers (180a) has a thickness ranging from about 30 nm to about 50 nm.

10. The array substrate according to claim 7, wherein:
each of the first and second active layers (180a) is made of indium gallium zinc oxide (IGZO), indium zinc oxide (IZO), indium-tin-zinc-oxide (ITZO), zinc oxide (ZnO), or a combination thereof.

11. A display panel, comprising the array substrate of any claim of claims 7-10.

12. A display apparatus, comprising the display panel of claim 11.

## Patentansprüche

1. Verfahren zur Herstellung eines Array-Substrats, umfassend:
Bilden einer ersten aktiven Schicht (120a), von Source/Drain-Bereichen und gemeinsamen Elektroden (125) auf einem Substrat (110) durch einen ersten Strukturierungsprozess, Bilden einer ersten Gate-Isolierschicht (130a) auf der ersten aktiven Schicht (120a) und Bilden einer Gate-Elektrode (140a) auf der ersten Gate-Isolierschicht (130a);
Bilden einer zweiten Gate-Isolierschicht (160) auf den gemeinsamen Elektroden (125) und der Gate-Elektrode (140a), und Bilden von Durchkontaktierungslöchern in der zweiten Gate-Isolierschicht (160) durch einen zweiten Strukturierungsprozess, um Oberflächenabschnitte der gemeinsamen Elektroden (125) freizulegen;
Bilden von Source/Drain-Elektroden (170 s/d), die über die Durchkontaktierungslöcher elektrisch mit den Source/Drain-Bereichen verbunden sind, durch einen dritten Strukturierungsprozess; und
Bilden einer zweiten aktiven Schicht (180a) über der Gate-Elektrode und Pixelelektroden auf der zweiten Gate-Isolierschicht (160) durch einen vierten Strukturierungsprozess.

2. Verfahren nach Anspruch 1, wobei:
der Schritt des Bildens einer ersten aktiven Schicht (120a), der Source/Drain-Bereiche und der gemeinsamen Elektroden (125) auf dem Substrat (110) umfasst: Bilden einer ersten Oxidschicht (120) zwischen dem Substrat (110) und der ersten Gate-Isolierschicht (130a), und
die erste Oxidschicht (120) einen ersten Abschnitt unter der ersten Gate-Isolierschicht (130a) hat, die als die erste aktive Schicht (120a) verwendet wird, und einen zweiten Abschnitt auf dem Substrat (110) hat, der in eine leitfähige Schicht umgewandelt wird, die als die Source/Drain-Bereiche und die gemeinsamen Elektroden (125) verwendet wird.

3. Verfahren nach Anspruch 2, wobei der zweite Abschnitt der ersten Oxidschicht (120) durch ein Plasma in die leitfähige Schicht umgewandelt wird.

4. Verfahren nach Anspruch 2, wobei der zweite Abschnitt der ersten Oxidschicht (120) durch ein Ionenimplantationsprozess in die leitfähige Schicht umgewandelt wird.

5. Verfahren nach Anspruch 2, ferner umfassend:
Verwenden einer ersten strukturierten Photoresistschicht (150) als Ätzmaske, um die erste aktive Schicht (120a), die Source/Drain-Bereiche, die gemeinsamen Elektroden (125), die erste Gate-Isolierschicht (130a) und die Gate-Elektrode (140a) zu bilden;
vorzugsweise, ferner umfassend:
Bilden einer ersten Isolierschicht (130) auf der ersten Oxidschicht (120) und einer Metallschicht auf der ersten Isolierschicht (130), und
Bilden der ersten strukturierten Photoresistschicht (150) auf der Metallschicht, die als Ätzmaske verwendet wird,
vorzugsweise, ferner umfassend:
Bilden eines Durchgangslochs (105) in der Metallschicht, der ersten Isolierschicht (130) und der ersten Oxidschicht (120), um das Substrat (110) freizulegen,
Entfernen eines ersten Abschnitts der ersten strukturierten Photoresistschicht (150), die das Durchgangsloch (105) enthält, um einen zweiten Abschnitt der ersten strukturierten Photoresistschicht (150) auf der Metallschicht zurückzulassen, und
Verwenden des zweiten Abschnitts der ersten strukturierten Photoresistschicht (150) als Ätzmaske zum Entfernen von Abschnitten der Metallschicht und der ersten Isolierschicht (130), um die erste Gate-Isolierschicht (130a) und die Gate-Elektrode (140a) vorzusehen,
vorzugsweise, wobei der Schritt des Verwendens des zweiten Abschnitts der ersten strukturierten Photoresistschicht (150) als eine Ätzmaske zum Entfernen von Abschnitten der ersten Isolierschicht (130) einen Trockenätzprozess unter Verwendung von Plasma umfasst,
vorzugsweise, wobei der Trockenätzprozess so gesteuert wird, dass das Plasma verwendet wird, um die erste Oxidschicht (120) gleichzeitig zu behandeln, um die erste Oxidschicht (120), die sich nicht unter der ersten Gate-Isolierschicht (130a) befindet, in die leitfähige Schicht umzuwandeln.

6. Verfahren nach Anspruch 1, wobei der Schritt des Bildens einer zweiten aktiven Schicht (180a) und von Pixelelektroden umfasst:
Bilden einer zweiten Oxidschicht (180) auf der zweiten Gate-Isolierschicht (160) und auf den Source/Drain-Elektroden (170 s/d), und
Bilden einer Schutzschicht (190) auf der zweiten Oxidschicht(180),
vorzugsweise, ferner umfassend:
nach dem Bilden der Source/Drain-Elektroden (170 s/d) und vor dem Bilden der zweiten aktiven Schicht (180a), Bilden einer zweiten strukturierten Photoresistschicht auf der Schutzschicht (190), und
Verwenden der zweiten strukturierten Photoresistschicht auf der Schutzschicht (190) als Ätzmaske, um die zweite aktive Schicht (180a) und die Pixelelektroden auf der zweiten Gate-Isolierschicht (160) zu bilden.

7. Array-Substrat, aufweisend:
eine erste Schichtstruktur, die eine erste aktive Schicht (120a), Source/Drain-Bereiche und gemeinsame Elektroden (125) auf einem Substrat (110) aufweist, wobei die erste aktive Schicht (120a), die Source/Drain-Bereiche und die gemeinsamen Elektroden (125) aus einer gleichen Schicht gebildet sind;
eine erste Gate-Isolierschicht (130a) auf der ersten aktiven Schicht (120a);
eine Gate-Elektrode (140a) auf der ersten Gate-Isolierschicht (130a);
eine zweite Gate-Isolierschicht (160) auf den Source/Drain-Bereichen, den gemeinsamen Elektroden (125) und der Gate-Elektrode (140a);
Source/Drain-Elektroden (170 s/d) in der zweiten Gate-Isolierschicht (160), die mit den Source/Drain-Bereichen verbunden sind;
eine zweite aktive Schicht (180a) auf der zweiten Gate-Isolierschicht (160), oberhalb der Gate-Elektrode (140a) und zwischen den Source/Drain-Elektroden (170 s/d); und
Pixelelektroden auf der zweiten Gate-Isolierschicht (160) .

8. Array-Substrat nach Anspruch 7, ferner aufweisend:
eine zweite Oxidschicht (180) auf der zweiten Gate-Isolierschicht (160) und auf den Source/Drain-Elektroden (170 s/d),
wobei die zweite Oxidschicht (180) einen ersten Abschnitt über der ersten Gate-Isolierschicht (130a) hat, der als die zweite aktive Schicht (180a) definiert ist, und einen zweiten Abschnitt hat, der in eine leitfähige Schicht umgewandelt wird, die als die Pixelelektroden definiert ist,
vorzugsweise, wobei:
der zweite Abschnitt der zweiten Oxidschicht (180) durch ein Plasma oder eine Ionenimplantation in die leitfähige Schicht umgewandelt wird.

9. Array-Substrat nach Anspruch 7, wobei:
jede der ersten und zweiten aktiven Schichten (180a) eine Dicke von etwa 30 nm bis etwa 50 nm hat.

10. Array-Substrat nach Anspruch 7, wobei:
jede der ersten und zweiten aktiven Schichten (180a) aus Indium-Gallium-Zinkoxid (IGZO), Indium-Zinkoxid (IZO), Indium-Zinn-Zinkoxid (ITZO), Zinkoxid (ZnO) oder einer Kombination davon hergestellt ist.

11. Anzeigetafel, das Array-Substrat nach einem beliebigen der Ansprüche 7-10 aufweisend.

12. Anzeigevorrichtung, die Anzeigetafel nach Anspruch 11 aufweisend.

## Revendications

1. Procédé de fabrication d'un substrat de réseau, comprenant les étapes consistant à :
former, par un premier processus de formation de motifs, une première couche active (120a), de régions source / drain et d'électrodes communes (125) sur un substrat (110), former une première couche isolante de grille (130a) sur la première couche active (120a), et former une électrode de grille (140a) sur la première couche isolante de grille (130a) ;
former une seconde couche isolante de grille (160) sur les électrodes communes (125) et l'électrode de grille (140a), et former, par un second processus de formation de motifs, des trous traversants dans la seconde couche isolante de grille (160) pour exposer des parties de surface des électrodes communes (125) ;
former, par un troisième processus de formation de motifs, des électrodes de source / drain (170 s/d) connectées électriquement aux régions de source / drain à travers les trous traversant ; et
former, par un quatrième processus de formation de motifs, une seconde couche active (180a) au-dessus de l'électrode de grille et des électrodes de pixel sur la seconde couche isolante de grille (160).

2. Procédé selon la revendication 1, dans lequel :
l'étape de formation d'une première couche active (120a), des régions de source / drain et des électrodes communes (125) sur le substrat (110) comprend : la formation d'une première couche d'oxyde (120) entre le substrat (110) et la première couche isolante de grille (130a), et
la première couche d'oxyde (120) a une première partie sous la première couche isolante de grille (130a) utilisée comme première couche active (120a), et a une seconde partie sur le substrat (110) qui est convertie en une couche conductrice utilisée en tant que régions de source / drain et électrodes communes (125).

3. Procédé selon la revendication 2, dans lequel la deuxième partie de la première couche d'oxyde (120) est convertie en couche conductrice par un plasma.

4. Procédé selon la revendication 2, dans lequel la seconde partie de la première couche d'oxyde (120) est convertie en couche conductrice par un procédé d'implantation ionique.

5. Procédé selon la revendication 2, comprenant en outre l'étape consistant à :
utiliser une première couche de résine photosensible « photorésist » à motifs (150) comme masque de gravure pour former la première couche active (120a), les régions de source / drain, les électrodes communes (125), la première couche isolante de grille (130a) et l'électrode de grille (140a) ;
de préférence, comprenant en outre les étapes consistant à :
former une première couche isolante (130) sur la première couche d'oxyde (120), et une couche métallique sur la première couche isolante (130), et former la première couche de photorésist à motifs (150) sur la couche métallique utilisée comme masque de gravure,
de préférence, comprenant en outre les étapes consistant à :
former un trou traversant (105) dans la couche métallique, la première couche isolante (130), et la première couche d'oxyde (120) pour exposer le substrat (110),
retirer une première partie de la première couche de photorésist à motifs (150) contenant le trou traversant (105) pour laisser une seconde partie de la première couche de photorésist à motifs (150) rester sur la couche métallique, et
utiliser la deuxième partie de la première couche de photorésist à motifs (150) comme masque de gravure pour retirer des parties de la couche métallique et de la première couche isolante (130), pour fournir la première couche isolante de grille (130a) et l'électrode de grille (140a),
de préférence, dans lequel l'étape d'utilisation de la seconde partie de la première couche de photorésist à motifs (150) comme masque de gravure pour enlever des parties de la première couche isolante (130) comprend un processus de gravure à sec utilisant un plasma,
de préférence, dans lequel le processus de gravure sèche est commandé pour utiliser le plasma pour traiter simultanément la première couche d'oxyde (120) pour convertir la première couche d'oxyde (120) qui n'est pas sous la première couche isolante de grille (130a) en couche conductrice.

6. Procédé selon la revendication 1, dans lequel l'étape de formation d'une seconde couche active (180a) et d'électrodes de pixels comprend les étapes consistant à :
former une seconde couche d'oxyde (180) sur la seconde couche isolante de grille (160) et sur les électrodes de source / drain (170 s/d), et
former une couche de protection (190) sur la seconde couche d'oxyde (180),
de préférence, comprenant en outre :
après avoir formé les électrodes de source / drain (170 s/d) et avant de former la deuxième couche active (180a), l'étape consistant à former une deuxième couche de photorésist à motifs sur la couche de protection (190), et
utiliser la deuxième couche de photorésist à motifs sur la couche de protection (190) comme masque de gravure pour former la deuxième couche active (180a) et les électrodes de pixel sur la deuxième couche isolante de grille (160).

7. Substrat de matrice, comprenant :
une première structure de couche comprenant une première couche active (120a), des régions de source / drain et des électrodes communes (125) sur un substrat (110), la première couche active (120a),
les régions de source / drain et les électrodes communes (125) sont formées à partir d'une même couche ;
une première couche isolante de grille (130a) sur la première couche active (120a) ;
une électrode de grille (140a) sur la première couche isolante de grille (130a) ;
une seconde couche isolante de grille (160) sur les régions de source / drain, les électrodes communes (125) et l'électrode de grille (140a) ;
électrodes de source / drain (170 s/d) dans la seconde couche isolante de grille (160) et connectant aux régions source / drain ;
une deuxième couche active (180a) sur la deuxième couche isolante de grille (160), au-dessus de l'électrode de grille (140a), et entre les électrodes de source / drain (170 s/d) ; et
des électrodes de pixel sur la seconde couche isolante de grille (160).

8. Substrat de réseau selon la revendication 7, comprenant en outre :
une deuxième couche d'oxyde (180) sur la deuxième couche isolante de grille (160) et sur les électrodes de source / drain (170 s/d),
dans lequel la deuxième couche d'oxyde (180) a une première partie sur la première couche isolante de grille (130a) définie comme deuxième couche active (180a), et a une deuxième partie qui est convertie en une couche conductrice définie comme électrodes de pixel,
de préférence, dans lequel :
la seconde partie de la seconde couche d'oxyde (180) est convertie en couche conductrice par un plasma ou une implantation ionique.

9. Substrat de réseau selon la revendication 7, dans lequel :
chacune des première et seconde couches actives (180a) a une épaisseur allant d'environ 30 nm à environ 50 nm.

10. Substrat de matrice selon la revendication 7, dans lequel :
chacune des première et seconde couches actives (180a) est constituée d'oxyde d'indium-gallium-zinc (IGZO), d'oxyde d'indium-zinc (IZO), d'oxyde d'indium-étain-zinc (ITZO), d'oxyde de zinc (ZnO) ou d'une de leur combinaison.

11. Panneau d'affichage, comprenant le substrat de matrice selon l'une quelconque des revendications 7 à 10.

12. Appareil d'affichage, comprenant le panneau d'affichage selon la revendication 11.
